# EUROPEAN PATENT APPLICATION

(11) **EP 4 418 336 A1**
(43) Date of publication of application: **21.08.2024**
(21) Application number: 22892400.7
(22) Date of filing: 12.09.2022
(51) Int. Cl.: H01L 33/62, H01S 5/0232

(54) **LIGHT-EMITTING DEVICE AND LEAD FRAME**

(30) Priority: 12.11.2021 JP 2021184652
(71) Applicant: Stanley Electric Co. Ltd., Tokyo 153-8636 (JP)
(72) Inventor: SHIMODA, Yoichi, Tokyo 153-8636 (JP); KAMBARA, Daizo, Tokyo 153-8636 (JP); SHIGEEDA, Yuji, Tokyo 153-8636 (JP); ICHIKAWA, Koji, Tokyo 153-8636 (JP); ISHIKO, Hiroyuki, Tokyo 153-8636 (JP)
(74) Representative: Schmidbauer, Andreas Konrad
(86) International application number: PCT/JP2022/034023
(87) International publication number: WO 2023/084899

(57) **Abstract**

A light-emitting device 10 includes a lead frame 12, a frame body 11 having an opening portion 20 and formed integrally with the lead frame 12, and an LED 28 that is connected to leads 12a and 12b of the lead frame 12 and is disposed within the opening portion 20. The lead frame 12 has a stacked structure including an upper second layer metal plate 122 and a lower third layer metal plate 123, and a penetration portion 125 penetrates the stacked structure in an up-down direction. The second layer metal plate 122 protrudes into the penetration portion 125 from the third layer metal plate 123 to form a step. A resin of the frame body 11 fills the penetration portion 125.

## Description

### Technical Field

The present invention relates to a light-emitting device and a lead frame used for the light-emitting device, and particularly to a light-emitting device including a semiconductor light-emitting element such as a light emitting diode (LED), and a lead frame used for the light-emitting device.

### Background Art

In the related art, a light-emitting device in which a resin body is provided on a lead frame by insert molding and is cut and formed by a dicer has been known.

For example, Patent Literature 1 discloses a method for forming a frame-shaped resin molded product on a lead frame in which a cutout portion is provided and cutting the resin molded product and the lead frame along the cutout portion to form a light-emitting device.

In addition, Patent Literature 2 discloses a surface-mounted light-emitting device that includes a frame-shaped first resin molded product formed by integrally molding a first lead for mounting a light-emitting element and a second lead electrically connected to the first lead, and a second resin molded product that is bonded to the first lead and the second lead on a lower side while covering the light-emitting element. Both the first resin molded product and the second resin molded product of the surface-mounted light-emitting device are thermosetting resins.

### Citation List

### Patent Literatures

Patent Literature 1: Japanese Patent Application Laid-Open No. 2010-62272
Patent Literature 2: Japanese Patent Application Laid-Open No. 2006-156704

### Summary of Invention

### Technical Problem

In the light-emitting device of Patent Literature 1, a resin of the resin molded product fills the cutout portion of the lead frame, and thus, adhesiveness between the resin molded product and the lead frame is improved. However, a height of a contact surface between the resin and the cutout portion is at most a thickness of the lead frame, and an increase in contact area is limited.

In the surface-mounted light-emitting device of Patent Literature 2, adhesiveness between the second resin molded product and the lead frame is improved, and thus, there is a possibility that the first resin molded product adhered to the second resin molded product with the thermosetting resins is more adhered to the lead frame through the second resin molded product.

However, in the related art, there is still room for sufficient improvement in the adhesiveness between the resin molded product and the lead frame.

The present invention has been made in view of the above-described viewpoint, and an object of the present invention is to provide a light-emitting device having a structure, which has excellent adhesiveness between a frame body made of resin and a lead frame made of metal, prevents the resin of the frame body and the lead frame from being peeled off, and is unlikely to cause a disconnection failure or the like, and a lead frame used for the light-emitting device.

### Solution to Problem

A light-emitting device of the present invention includes
a lead frame that has a plurality of leads formed from a common stacked structure in which at least two layers are stacked, the plurality of leads having a penetration portion penetrating at least two layers from an upper layer of the stacked structure, and an upper side layer and a lower side layer of two layers having the penetration portion protruding with different amounts of protruding with respect to the penetration portion to form a step,
a frame body made of resin that has an opening portion through which the plurality of leads is exposed, the frame body filling the penetration portion, and being provided to surround the opening portion in an upper portion of the lead frame, and
a light-emitting element that is mounted within the opening portion and is connected to the plurality of leads.

A lead frame of the present invention includes
a plurality of leads formed from a common stacked structure in which at least two layers are stacked,
in which the plurality of leads has a penetration portion penetrating at least two layers from an upper layer of the stacked structure, and
an upper side layer and a lower side layer of two layers having the penetration portion protrude with different amounts of protruding with respect to the penetration portion to form a step.

### Brief Description of Drawings

FIG. 1 is a perspective view schematically illustrating a light-emitting device according to a first embodiment of the present invention.
FIG. 2 is a diagram illustrating an upper surface of the light-emitting device.
FIG. 3 is a top view schematically illustrating an inside of the light-emitting device.
FIG. 4 is a sectional view of a portion taken along a line segment IV-IV of FIG. 3.
FIG. 5 is a sectional view taken along a line V-V of FIG. 2.
FIG. 6 is an enlarged sectional view illustrating an enlarged right half portion of FIG. 5.
FIG. 7 is a sectional view taken along a line VII-VII of FIG. 3.
FIG. 8A is a bottom view of the light-emitting device.
FIG. 8B is a side view viewed in a direction indicated by an arrow VIIIB of FIG. 2.
FIG. 8C is a side view viewed in a direction indicated by an arrow VIIIC of FIG. 2.
FIG. 9A is a top view of a lead frame according to the first embodiment.
FIG. 9B is a bottom view of the lead frame of FIG. 9A.
FIG. 9C is a sectional view taken along a line IXC-IXC of FIG. 9A.
FIG. 9D is a sectional view taken along a line IXD-IXD of FIG. 9A.
FIG. 10A is a top view of a lead frame according to Modification Example 1 of the first embodiment.
FIG. 10B is a sectional view taken along a line XB-XB of FIG. 10A.
FIG. 11A is a top view of a lead of a lead frame included in Modification Example 2 of the first embodiment.
FIG. 11B is a diagram illustrating a sectional structure of a first example of a lead indicated by an arrow XIB of FIG. 11A.
FIG. 11C is a diagram illustrating a sectional structure of a second example of the lead indicated by the arrow XIB of FIG. 11A.
FIG. 11D is a diagram illustrating a sectional structure of a third example of the lead indicated by the arrow XIB of FIG. 11A.
FIG. 11E is a diagram illustrating a sectional structure of a fourth example of the lead indicated by the arrow XIB of FIG. 11A.
FIG. 11F is a sectional view illustrating a state where a frame body is provided in the lead of FIG. 11B.
FIG. 11G is a sectional view illustrating a state where the frame body is provided in a lead section of a line XIG-XIG of FIG. 11A.
FIG. 12A is a structural diagram of the lead frame.
FIG. 12B is a diagram illustrating STEP2 of a method for manufacturing a light-emitting device.
FIG. 12C is a diagram illustrating STEP3 of the method for manufacturing the light-emitting device.
FIG. 12D is a diagram illustrating STEP4 of the method for manufacturing the light-emitting device.
FIG. 13A is a top view schematically illustrating an upper surface of the light-emitting device.
FIG. 13B is a bottom view of the light-emitting device.
FIG. 13C is a side view viewed from a direction illustrated by XIIIC of FIG. 13A.
FIG. 13D is a sectional view taken along XIIID-XIIID of FIG. 13A.
FIG. 13E is a sectional view taken along XIIIE-XIIIE of FIG. 13A.

### Description of Embodiments

Hereinafter, preferred embodiments of the present invention will be described, but these embodiments may be appropriately modified and combined. In addition, in the following description and the accompanying drawings, substantially the same or equivalent parts will be described with the same reference numerals.

### [First Embodiment]

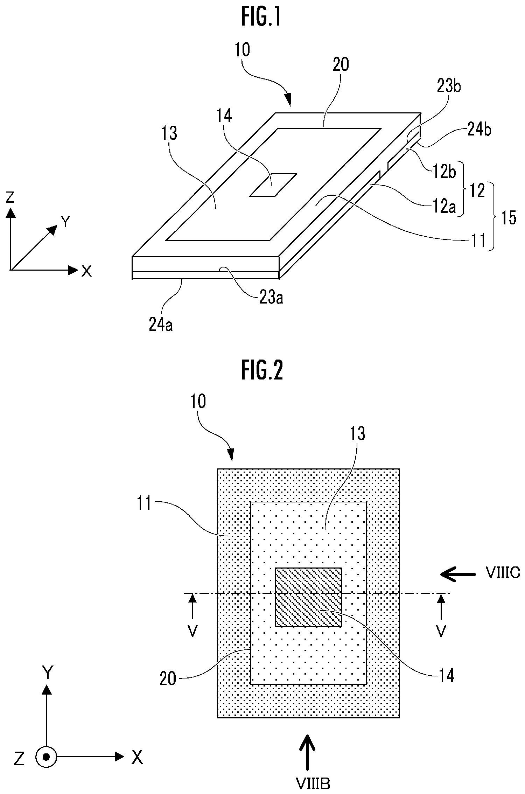

FIG. 1 is a perspective view schematically illustrating a light-emitting device 10 according to a first embodiment of the present invention, and FIG. 2 is a diagram illustrating an upper surface of the light-emitting device 10. Note that, a three-axis coordinate system is added for the sake of convenience of indicating a correspondence direction between a plurality of figures. A Z direction corresponds to an up-down direction of the light-emitting device 10, and an X direction and a Y direction correspond to a lateral direction and a longitudinal direction of the light-emitting device 10, respectively.

In FIG. 1, the light-emitting device 10 includes a substrate 15 including an upper rectangular frame body 11 and a lower lead frame 12. In the light-emitting device 10 according to the present embodiment, the substrate 15 has an outer periphery having a rectangular parallelepiped shape. The lead frame 12 has leads 12a and 12b spaced apart from each other.

As illustrated in FIGS. 1 and 2, a covering member 13 is provided inside the frame body 11, and a phosphor plate 14 is exposed from the covering member 13. The frame body 11 is made of, for example, a thermosetting resin material, and has an opening portion 20. The frame body 11 extends over the entire circumference of the light-emitting device 10 with a width with which a predetermined adhesive area with the lead frame 12 made of a plate-like metal can be ensured.

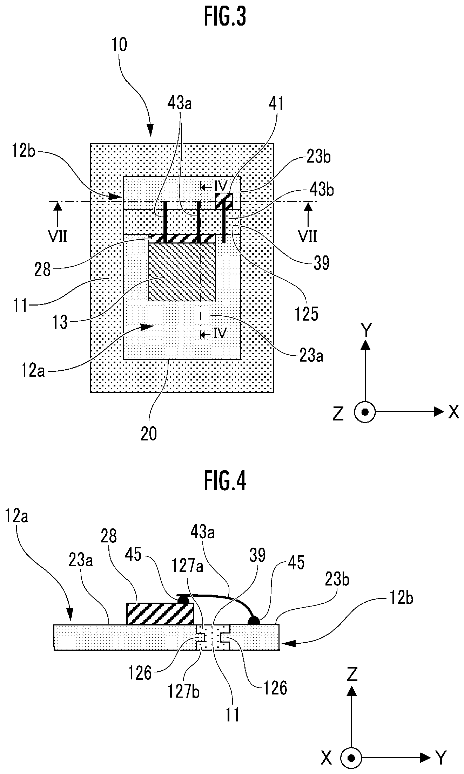

FIG. 3 is a top view schematically illustrating an inside of the light-emitting device 10. FIG. 3 does not illustrate the covering member 13 (see FIG. 1) that covers the opening portion 20. An upper surface 23a of the lead 12a and an upper surface 23b of the lead 12b are exposed to the opening portion 20 of the frame body 11. The thermosetting resin of the frame body 11 fills a slit 39, and adhesiveness between the frame body 11 and the lead frame 12 is improved.

FIG. 4 is a sectional view of a portion of a line segment IV-IV of FIG. 3. As illustrated in FIGS. 3 and 4, the upper surface 23a of the lead 12a and the upper surface 23b of the lead 12b are partially exposed in the opening portion 20. An LED 28 and a protective element 41 are mounted on portions where the upper surface 23a and the upper surface 23b are exposed within the opening portion 20. The LED 28 is connected to the upper surface 23b of the lead 12b through two bonding wires 43a. The protective element 41 is connected to the upper surface 23a of the lead 12a through a bonding wire 43b. The protective element 41 includes, for example, a Zener diode, a varistor, or a capacitor, and prevents an overcurrent from flowing through the LED 28.

In this embodiment, the leads 12a and 12b are used as a cathode and an anode, respectively. Applied voltages to the leads 12a and 12b are supplied from an outside of the light-emitting device 10. The reason why two bonding wires 43a are provided in parallel is to ensure the amount of power supplied to the LED 28. However, the number of bonding wires 43a is not limited thereto.

Similarly to the bonding wire 43a, the bonding wire 43b also connects the upper surface 23a and the protective element 41 to each other via bumps on the upper surface 23a of the lead 12a and an electrode pad (not illustrated) of an upper surface of the protective element 41.

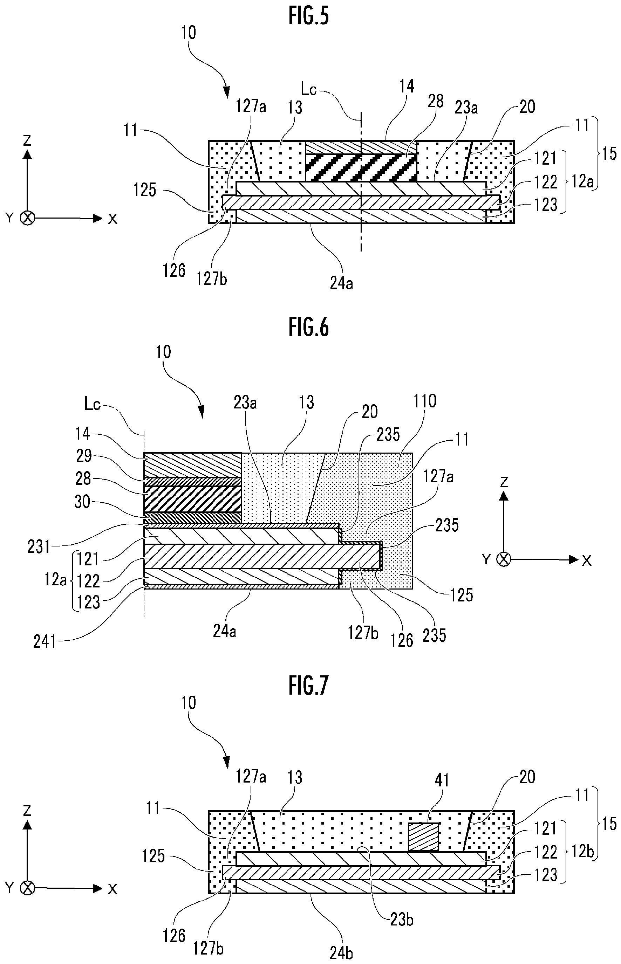

FIG. 5 is a sectional view taken along a line V-V of FIG. 2. The opening portion 20 of the frame body 11 has a shape of an inverted quadrangular pyramid having a rectangular bottom surface. In addition, inside the frame body 11, the LED 28 is implemented on the lead 12a, and the phosphor plate 14 which is a wavelength converter is provided on the LED 28.

FIG. 6 is an enlarged sectional view illustrating an enlarged right half portion of FIG. 5. Note that, a center line Lc of the substrate 15 is illustrated as an auxiliary line. An example in which the LED 28 is mounted on the upper surface 23a of the lead 12a via a bonding layer 30 will be described in detail with reference to FIG. 6. The bonding layer 30 is made of a solder material. The phosphor plate 14 is adhered to the upper surface of the LED 28 via a transparent adhesive layer 29.

The covering member 13 fills the opening portion 20 to seal the opening portion 20. The covering member 13 is made of, for example, a silicone resin containing titanium oxide particles having a particle size of ϕ200 nm to 300 nm as a light reflective material.

The LED 28 is, for example, a light-emitting element that emits blue light. A part of the blue light emitted upward (+Z direction) from the LED 28 is wavelength-converted into, for example, yellow light in a case of passing through the phosphor plate 14. As a result, the emitted light from the light-emitting device 10 is white light of a mixed color of blue light and yellow light, which is transmitted through the phosphor plate 14 without being wavelength-converted.

The light emitted from the LED 28 in the lateral direction (X direction and Y direction) and incident on the covering member 13 is reflected by the light reflective material contained in the covering member 13.

The light emitted from the LED 28 is not limited to blue light, and may be light in a visible light band, such as red light and green light, light outside the visible light band, such as ultraviolet light and infrared light, or the like. In addition, an optical element having light transmittance may be provided on the LED 28, which is not limited to the wavelength converter (phosphor plate 14).

FIG. 7 is a sectional view taken along a line VII-VII of FIG. 3. A stacked structure and a penetration portion 125 of the lead frame 12 will be described with reference to FIGS. 5 to 7. The lead frame 12 has a stacked structure including a plurality of metal plate layers lined up in order from top, that is, a first layer metal plate 121, a second layer metal plate 122, and a third layer metal plate 123. Note that, the leads 12a and 12b are structural units including an anode electrode and a cathode electrode of the light-emitting device 10 in which the lead frame 12 is separated in the longitudinal direction by the slit 39. On the other hand, the stacked structure of the lead frame 12 is a stacked structure in a thickness direction common to the leads 12a and 12b.

In the stacked structure of the lead frame 12, the adjacent upper and lower metal plates are diffusion-bonded to each other or are brazed to each other. An upper surface of the first layer metal plate 121 constitutes the upper surface 23a of the lead 12a and the upper surface 23b of the lead 12b. A lower surface of the third layer metal plate 123 constitutes a lower surface 24a of the lead 12a and a lower surface 24b of the lead 12b.

On the other hand, the penetration portion 125 is formed as a hole portion penetrating the lead frame 12 in the light-emitting device 10. Specifically, as illustrated in FIGS. 5 and 6, the penetration portion 125 is a plate punched portion penetrating an upper surface and a lower surface of each of the metal plates of the first layer metal plate 121, the second layer metal plate 122, and the third layer metal plate 123.

The second layer metal plate 122 has a protruding portion 126 that protrudes toward the penetration portion 125 from an edge of the upper first layer metal plate 121 and an edge of the lower third layer metal plate 123. In a case where the amounts of protrusion into the penetration portion 125 are compared, the second layer metal plate 122 has a larger amount of protrusion than the first layer metal plate 121 and the third layer metal plate 123.

As a result, in the penetration portion 125, expansion portions 127a and 127b are formed on a side of the first layer metal plate 121 and a side of the third layer metal plate 123 on a lower side layer with respect to the protruding portion 126 of the second layer metal plate 122. The resin of the frame body 11 fills the penetration portion 125. Accordingly, the resin of the frame body 11 filling the expansion portions 127a and 127b of the penetration portion 125 sandwiches the protruding portion 126 of the second layer metal plate 122 from both sides in the up-down direction.

In the enlarged view of FIG. 6, the upper surface 23a and the lower surface 24a of the lead 12a are covered with plating films 231 and 241. Within the penetration portion 125, side surfaces of the first layer metal plate 121, the second layer metal plate 122, and the third layer metal plate 123 are covered with an oxide film 235.

In the light-emitting device 10, the first layer metal plate 121, the second layer metal plate 122, and the third layer metal plate 123 are made of, for example, copper (Cu). The plating films 231 and 241 have, for example, a two-layer structure (Ni/Au) including nickel (Ni) of a lower layer of and gold (Au) of an upper layer. The oxide film 235 is made of, for example, copper oxide. The plating films 231 and 241 improve adhesiveness and wettability of solder. On the other hand, the oxide film 235 improves adhesiveness between a resin constituting the frame body 11 within the penetration portion 125 and a surface constituting the penetration portion 125 of the lead frame 12.

FIG. 7 is a sectional view taken along a line VII-VII of FIG. 3. In the sectional view of FIG. 7, the lead 12b is exposed on a lower surface of the light-emitting device 10 to define a part of a bottom surface of the light-emitting device 10. In addition, the lead 12b is covered with the frame body 11 that covers both end portions of a side surface and the upper surface 23b. The covering member 13 is embedded in the opening portion 20 defined by the upper surface 23b of the lead 12b and an inner surface of the frame body 11. In addition, the protective element 41 mounted on the upper surface 23b of the lead 12b via a bonding layer (not illustrated) is covered with the covering member 13 in which the opening portion 20 is embedded.

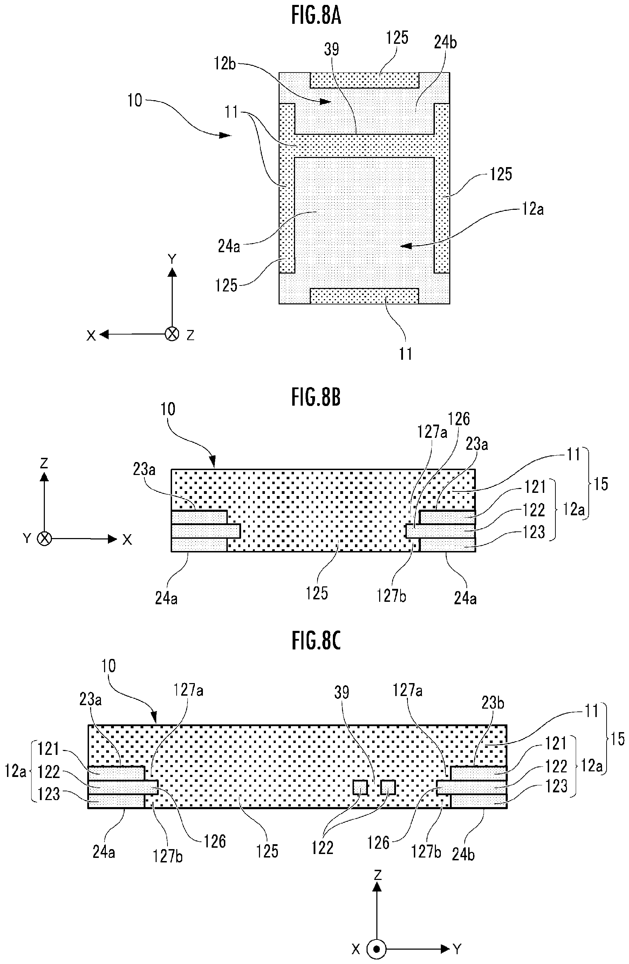

FIG. 8A is a bottom view of the light-emitting device 10. In addition, FIG. 8B is a side view viewed from a direction indicated by an arrow VIIIB of FIG. 2, and FIG. 8C is a side view viewed from a direction indicated by an arrow VIIIC of FIG. 2.

In the bottom view of FIG. 8A, the resin of the frame body 11 fills penetration portions 125 at a total of five locations formed by overlapping hole portions (plate punched portions) provided in the first layer metal plate 121, the second layer metal plate 122, and the third layer metal plate 123 on a lower surface of the lead frame 12. Each of the penetration portions is defined by an edge portion of the lead 12a and/or the lead 12b. Penetration portions 125 at four locations of the five locations extend along four sides of the light-emitting device 10, except for portions of four corners of the lead frame 12. The penetration portion 125 at the remaining one location is a portion where the lead 12a and the lead 12b face each other and are spaced apart from each other, and also serves as the slit 39.

In FIGS. 8B and 8C, each outer side surface of the substrate 15 has a rectangular shape, and includes the frame body 11 and the lead frame 12. Most of each outer side surface of the substrate is occupied by an outer side surface of the frame body 11. The lead 12a or the lead 12b of the lead frame 12 is exposed at both end portions of a lower side portion on each outer side surface. On each outer side surface, a region sandwiched between the lead 12a or the lead 12b forms the penetration portion 125, and is filled with the resin of the frame body 11.

In FIG. 8C, a pair of second layer metal plates 122 is exposed to be isolated at an intermediate portion of the frame body 11 in the longitudinal direction (Y direction of FIG. 8C). In the pair of second layer metal plates 122 exposed to be isolated at the intermediate portion, one plate (left side in the drawing) is an end portion of a portion extended from the lead 12a, and the other plate (right side in the drawing) is an end portion of a portion extended from the lead 12b.

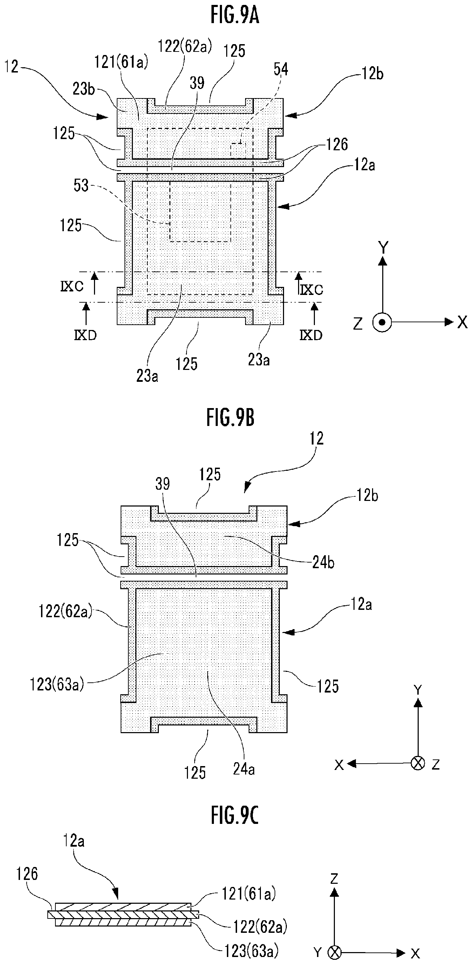

Next, a detailed structure of the lead frame 12 will be described. FIG. 9A is a top view of the lead frame 12 according to the first embodiment, and FIG. 9B is a bottom view of the lead frame 12 of FIG. 9A.

The lead frame 12 has a three-layer structure of the first layer metal plate 121, the second layer metal plate 122, and the third layer metal plate 123, and has the slit 39 that divides the lead frame into two in the longitudinal direction (Y direction) and four penetration portions 125 penetrating the entire thickness direction of the lead frame 12.

In FIG. 9A, the slit 39 extends over the entire length of the lead frame 12 in the lateral direction (X direction) while being sandwiched between the second layer metal plate 122 of the lead 12a and the second layer metal plate 122 of the lead 12b in the longitudinal direction (Y direction) of the lead frame 12. Then, the facing edges of the second layer metal plate 122 protruding along the slit 39 reach a peripheral edge of the outer side surface of the light-emitting device 10 in the longitudinal direction in the lead frame 12 in the lateral direction. As a result, the pair of second layer metal plates 122 that sandwich the slit 39 from both sides of FIG. 8C described above are exposed on the side surface of the light-emitting device 10 in the longitudinal direction.

The upper surface 23a of the lead 12a and the upper surface 23b of the lead 12b are also the upper surface of the first layer metal plate 121 constituting an uppermost layer of the stacked structure of the lead frame 12. Regions forming die pads 53 and 54, respectively, are set on the upper surfaces 23a and 23b. The LED 28 and the protective element 41 are mounted on the die pads 53 and 54.

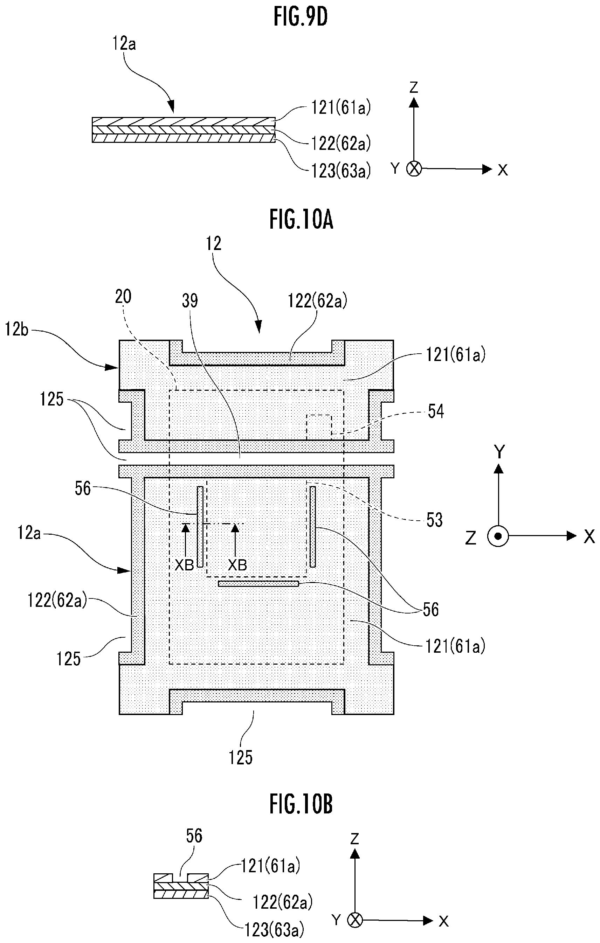

FIG. 9C is a sectional view taken along a line IXC-IXC of FIG. 9A, and FIG. 9D is a sectional view taken along a line IXD-IXD of FIG. 9A.

In FIGS. 9C and 9A, both left and right side surfaces of the lead 12a are side surfaces of the penetration portion 125. The protruding portion 126 of the second layer metal plate 122 protrudes from the first layer metal plate 121 and the third layer metal plate 123 on the upper side and the lower side, respectively, toward the penetration portion 125. Accordingly, the penetration portion 125 has a step.

On the other hand, in FIG. 9D, both the left and right side surfaces of the lead 12a are exposed on the outer side surface of the light-emitting device 10. That is, the side surfaces of the first layer metal plate 121, the second layer metal plate 122, and the third layer metal plate 123 are aligned to be flush with each other.

Note that, it is preferable that the lead frame 12 has a structure that is bilateral symmetric with respect to a center line in the longitudinal direction.

Hereinafter, modification examples of the first embodiment will be described. In various modification examples, the description of parts similar to those in the first embodiment will be omitted, and only differences will be described.

First, Modification Example 1 will be described. FIG. 10A is a top view of a lead frame 12 according to Modification Example 1 of the first embodiment, and FIG. 10B is a sectional view taken along a line XB-XB of FIG. 10A. The same reference numerals as those in FIG. 9A are added to the structural portions having the same structure as the lead frame 12 in FIG. 9A, and the description thereof will be omitted.

A feature of the lead frame 12 according to Modification Example 1 of the first embodiment of FIG. 10A is that the lead 12a has an alignment groove 56. Note that, as can be seen from FIG. 10B, the alignment groove 56 is formed in the first layer metal plate 121 of the uppermost layer in a metal plate stacked structure of the lead frame 12.

The LED 28 is mounted on the die pad 53 of the first layer metal plate 121 via the bonding layer 30. As illustrated in the drawing, the alignment groove 56 is formed in a rectangular shape outside the die pad 53 along three sides of four sides of the die pad 53 except for one side on the slit 39 side. The alignment groove 56 is formed simultaneously in a pattern forming step of a copper plate (base plate) to be described later, which forms the first layer metal plate 121.

The alignment groove 56 prevents the solder forming the bonding layer 30 from flowing out from the die pad 53 while being in a molten state when the LED 28 is bonded to the die pad 53, and simultaneously enables the LED 28 to be self-aligned within a region of the die pad 53.

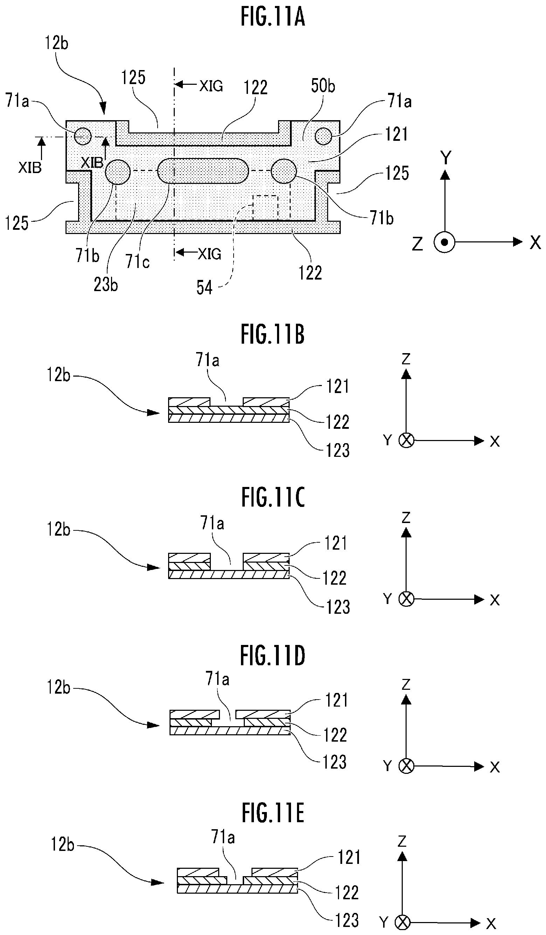

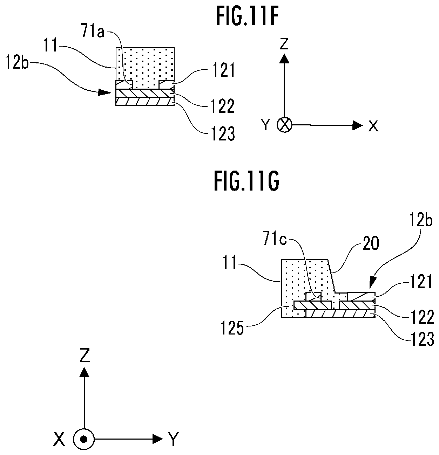

Next, Modification Example 2 of the first embodiment will be described. FIG. 11A is a top view of a lead 12b of a lead frame 12 of Modification Example 2 of the first embodiment. FIGS. 11B to 11E are diagrams illustrating various sectional structures of the lead 12b indicated by an arrow XIB of FIG. 11A. FIG. 11F is a sectional view illustrating the lead 12b of FIG. 11B in an integrated molding state with the frame body 11, and FIG. 11G is a sectional view illustrating the lead 12b of FIG. 11A in an integrated molding state with the frame body 11 along a line XIG-XIG.

The lead 12b of the lead frame 12 according to Modification Example 2 has anchor holes 71 (general term of anchor holes 71a, 71b, and 71c). It is preferable that the lead 12b having the anchor holes 71 has a structure that is bilateral symmetric with respect to a center line in the longitudinal direction of the lead frame 12.

The anchor hole 71a is formed in a circular shape at two corners of four corners of the rectangular lead frame 12, which are present in the lead 12b. The anchor holes 71b and 71c are formed along an edge of the bottom surface (rectangle) of the opening portion 20 indicated by a broken line of FIG. 11A. Specifically, the anchor hole 71b is formed in a circular shape at a corner portion of the bottom surface of the opening portion 20, and the anchor hole 71c is formed as an ellipse extending along a short side (side in the X direction) of the bottom surface.

As illustrated in FIGS. 11E and 11F, a part or all of the anchor holes 71 is embedded in the frame body 11. In other words, the resin in which the anchor hole 71 is embedded is a part of the frame body 11. In addition, the anchor hole 71 can also be circular such as a circle, an ellipse, and an oval, or polygonal such as a triangle, a quadrangle, and a pentagon. Each anchor hole 71 increases a contact area between the lead frame 12 and the frame body 11, and thus, peeling resistance of both the lead frame and the frame body is improved. In addition, since an engagement structure in which the anchor hole 71 has a recess shape and a part of the frame body 11 has a protrusion shape is achieved, peeling-resistance strength is improved in terms of the structure.

The anchor hole 71a of FIGS. 11B and 11C is formed as a circular columnar hole. The anchor hole 71a of FIG. 11B is formed only in the first layer metal plate 121. The anchor hole 71a of FIG. 11C is formed at a depth of two layers of the first layer metal plate 121 and the second layer metal plate 122 from the upper surface. The peeling resistance between the lead frame 12 and the frame body 11 can be improved by deepening the anchor holes 71. In addition, a structure in which the anchor holes are not exposed on a back surface of the lead frame 12 (lower surface of the light-emitting device 10) is adopted, and thus, it is possible to prevent a void from being introduced into the solder for fixing the light-emitting device 10 to a circuit board.

Similarly to the anchor hole 71a of FIG. 11C, the anchor hole 71a of FIGS. 11D and 11E is formed at a depth with which the anchor hole penetrates through two layers of the first layer metal plate 121 and the second layer metal plate 122 from the upper surface.

In the anchor hole 71a of FIG. 11D, a diameter of the circle is larger in the lower second layer metal plate 122 than in the upper first layer metal plate 121. In the anchor hole 71a of FIG. 11E, conversely, a diameter of the circle is smaller in the lower second layer metal plate 122 than in the upper first layer metal plate 121. The peeling resistance between a part of the frame body 11 in which the anchor hole 71 is embedded and the lead frame 12 in the up-down direction is improved in a case where a hole diameter of the second layer metal plate 122 is larger than a hole diameter of the first layer metal plate 121.

Since the anchor hole 71a of FIGS. 11D and 11E has a small hole diameter, but penetrates through two layers of the first layer metal plate 121 and the second layer metal plate 122 and has a step, the anchor hole functions as the penetration portion. In addition, the number and the position of anchor holes 71a are not limited to the illustrated number and position. Further, similarly to the anchor hole 71a, the anchor holes 71b and 71c can also be through-holes with steps.

Although the anchor holes 71 of the lead 12b have been described above, the anchor holes 71 can also be similarly provided in the lead 12a. In addition, the anchor holes 71 can also be provided in the longitudinal direction (Y direction) of the lead 12a and/or 12b. The anchor holes 71 not only improve the peeling resistance between the lead frame 12 and the frame body 11, but also improve mechanical strength against bending or twisting of the substrate 15. Accordingly, it is possible to prevent the breakage of the covering member 13 in which the opening portion 20 is embedded and disconnection of the bonding wires 43a and 43b of the light-emitting device 10 and the protective element 41 mounted on the lead 12a and the lead 12b.

### (Manufacturing method)

As for a manufacturing method, a method for manufacturing the lead frame used in the first embodiment will be described, and then a method for manufacturing the light-emitting device 10 according to the first embodiment will be described. Note that, in a manufacturing process, an example in which light-emitting devices 10 are manufactured in a state where a plurality of light-emitting devices is connected will be described.

### (Manufacturing method of lead frame)

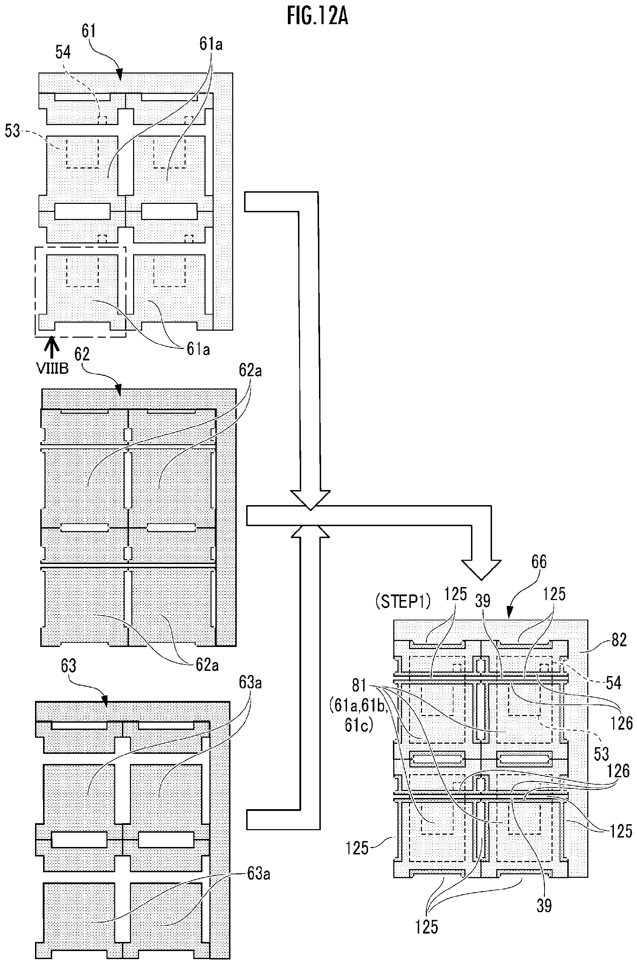

FIG. 12A is a schematic view illustrating a lead frame 66 (right side in the drawing) in a state where lead frames 12 forming the plurality of light-emitting devices 10 are connected to each other and a first molded metal plate 61, a second molded metal plate 62, and a third molded metal plate 63 (left side in the drawing) forming the lead frame 66 in a connected state as viewed from an upper surface. In addition, in this drawing, only upper right corners of the lead frame 66 and the molded metal plates 61, 62, and 63 are illustrated. Note that, the first molded metal plate 61, the second molded metal plate 62, and the third molded metal plate 63 are members forming the first layer metal plate 121, the second layer metal plate 122, and the third layer metal plate 123, respectively. Hereinafter, the first molded metal plate 61, the second molded metal plate 62, and the third molded metal plate 63 will be referred to as the molded metal plates in a case where the first, second, and third molded metal plate are not particularly distinguished from each other.

The lead frame 66 includes a plurality of unit divisions 81 arrayed in a lattice shape and a margin 82 surrounding peripheries of the plurality of arrayed unit divisions 81. The unit division 81 corresponds to one lead frame 12 in the light-emitting device 10, and has a stacked structure of three unit divisions 61a, 62a, and 63a of the first molded metal plate 61, the second molded metal plate 62, and the third molded metal plate 63.

First, nickel (Ni) and gold (Au) are stacked on one surface of a planar copper plate in the order of description (surface layer forming step). Specifically, one surface of the copper plate was protected with a protective resin, and Ni and Au layers were stacked on the other surface by an electroplating method. A single-side stacked plate in which the Ni and Au layers are stacked on the copper plate is used to form the first molded metal plate 61 and the third molded metal plate 63 in a next step. The Ni and Au layers can be formed by a vapor deposition method, a sputtering method, a chemical vapor deposition (CVD) method, or the like, in addition to the electroplating method.

Subsequently, the first molded metal plate 61, the second molded metal plate 62, and the third molded metal plate 63 are formed by performing a pattern forming process on the single-side stacked plate and the copper plate (pattern forming step). Specifically, the single-side stacked plate is processed into the first molded metal plate 61 and the third molded metal plate 63 by a press punching process. Similarly, the copper plate is processed into the second molded metal plate 62. The pattern formation can be performed by a laser cutting process, water jet cutting process, an etching process, or the like, in addition to the press punching process.

Note that, the through-hole forming the alignment groove 56 of Modification Example 1 and/or the through-hole forming the anchor hole 71 of the modification example 2 can be formed by processing the corresponding single-side stacked plate and/or copper plate in the present step.

Subsequently, the molded metal plates 61, 62, and 63 are overlapped and bonded to each other to form the lead frame 66 (lead bonding step). Specifically, the upper surface of the second molded metal plate 62 is overlapped with a lower surface (copper exposed surface) of the first molded metal plate 61 to face each other, and a lower surface of the second molded metal plate 62 is overlapped with the upper surface (copper exposed surface) of the third molded metal plate 63 to face each other. Subsequently, the first molded metal plate 61, the second molded metal plate 62, and the third molded metal plate 63 are integrated with each other by a thermal diffusion bonding method to form the lead frame 66. In addition to the thermal diffusion bonding method, a soldering method, an ultrasonic bonding method, an electric welding method, or the like can be used for the bonding of the molded metal plates 61, 62, and 63.

Finally, an oxidation treatment is performed on a surface of the lead frame 66, on which copper of an inner surface of the penetration portion 125 or the like is exposed (lead oxidation step). Specifically, the lead frame 66 is exposed to a dry air atmosphere at 150°C to 200°C for 30 to 180 minutes to form a copper oxide film on the copper exposed surface of the lead frame 66. An adhesive force with the resin material forming the frame body 11 is improved by providing a metal oxide film surface on a surface of the copper plate. In addition, in the alignment groove 56, since molten solder forming the bonding layer 30 is repelled, solder leakage from the region of the die pad 53 can be prevented. Note that the Ni and Au is not oxidized, since its surface is stacked on the copper plate.

### (Method for manufacturing light-emitting device)

Next, the method for manufacturing the light-emitting device 10 will be described. FIGS. 12A to 12D illustrate the method for manufacturing the light-emitting device 10 in the order of steps.

In STEP1, the lead frame 66 on a lower right side of FIG. 12A is prepared. The lead frame 66 includes the plurality of unit divisions 81 arrayed in the lattice shape and the margin 82 surrounding the peripheries of the lattice array regions of the plurality of unit divisions 81.

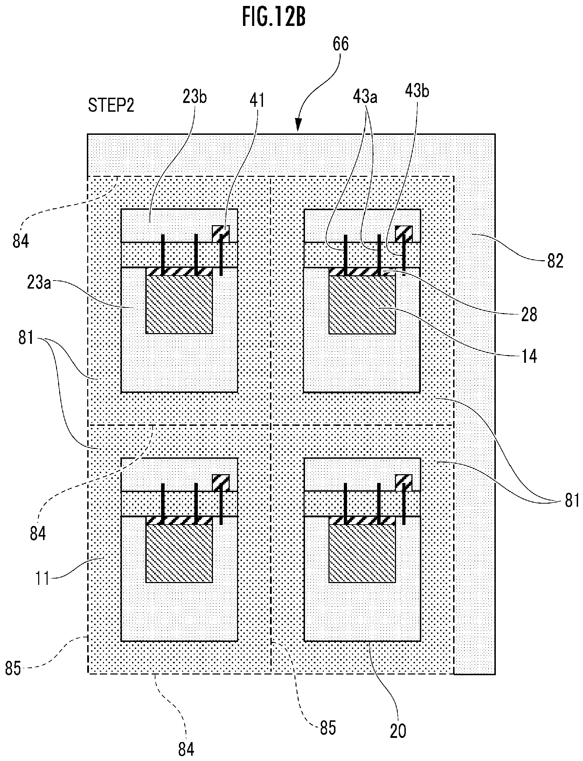

In FIGS. 12B to 12D illustrating the following STEP2 to STEP4, lateral dicing lines 84 and longitudinal dicing lines 85 for dividing the lead frame 66 into the unit divisions 81 are each illustrated by a broken line extending in the lateral direction and the longitudinal direction. The lateral dicing lines 84 and the longitudinal dicing lines 85 are not actually present as structures in the lead frame 66, and boundary lines of the unit divisions 81 are added as auxiliary lines for the sake of convenience in description.

In STEP2 of FIG. 12B, the frame body 11 is formed on the lead frame 66 by a transfer molding method. Specifically, the lead frame 66 is set in a predetermined position in a lower mold, and an upper mold having a recess forming the frame body 11 is covered to close the mold. Subsequently, the frame body 11 is formed on the lead frame 66 by feeding the resin forming the frame body 11 into a gap of a closed mold and heating and curing the resin. Each frame body 11 has the opening portion 20 that is open upward at a central portion. The upper surfaces 23a and 23b of the leads 12a and 12b are exposed to the opening portion 20.

In the STEP2 of FIG. 12B, solder (for example, gold-tin solder) forming the bonding layer 30 is applied to the die pads 53 and 54 (FIG. 9A) of the upper surface 23a of the frame body 11 and the upper surface 23b of the frame body 11, which are exposed to the opening portion 20, and the LED 28 and the protective element 41 are mounted thereon. Subsequently, the LED 28 and the protective element 41 are bonded to each other by melting and solidifying the solder in a solder reflow device.

Subsequently, a translucent silicone resin forming the adhesive layer 29 is applied onto the LED 28, and the phosphor plate 14 is mounted thereon. Subsequently, the silicone resin is heated to be cured, and thus, the phosphor plate 14 is adhered. Thereafter, the LED 28 and the upper surface 23b are connected to each other by the bonding wire 43a, and the protective element 41 and the upper surface 23a are connected to each other by the bonding wire 43b.

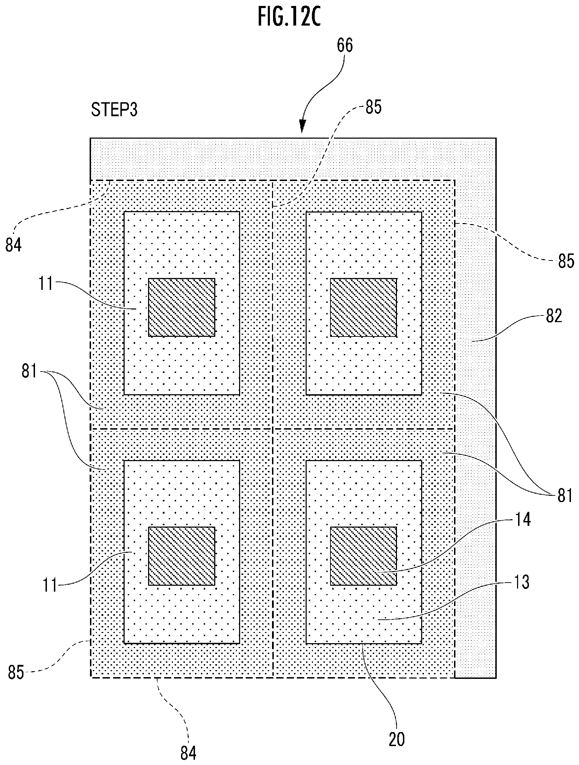

In STEP3 of FIG. 12C, the opening portion 20 is covered and sealed with the covering member 13. Specifically, the opening portion 20 is filled with a light reflective resin in which titanium oxide particles having a particle diameter of 200 nm to 300 nm are mixed with a silicone resin such that the side surfaces of the frame body 11 and the phosphor plate 14 are covered and the upper surface of the phosphor plate 14 is exposed. Subsequently, the covering member 13 is heated at 150°C for 90 minutes to cure the light reflective resin, and thus, the covering member is formed. In this manner, the plurality of light-emitting devices 10 is completed in a coupled state in the lattice array on the common lead frame 66.

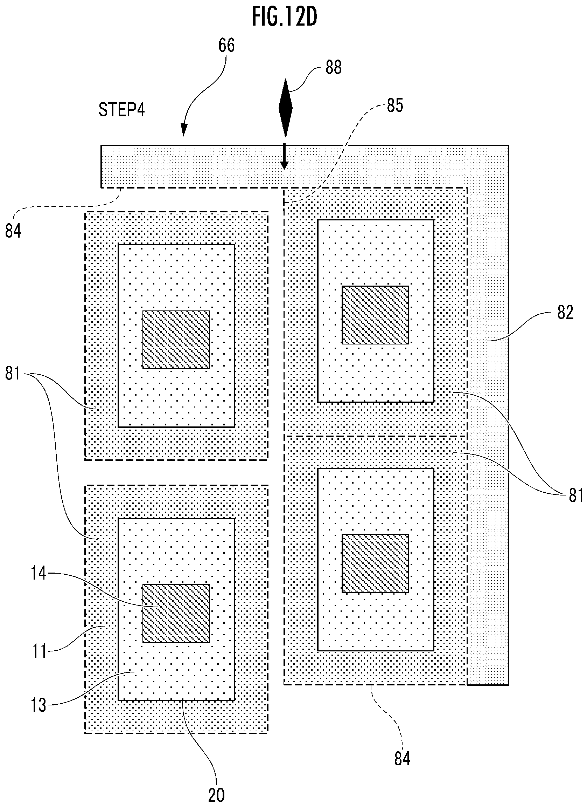

In STEP4 of FIG. 12D, dicing is performed by a dicing blade 68 along the lateral dicing lines 84 and the longitudinal dicing lines 85 with respect to the lattice array of the plurality of light-emitting devices 10 in STEP3. Accordingly, individual light-emitting devices 10 are completed.

### [Second Embodiment]

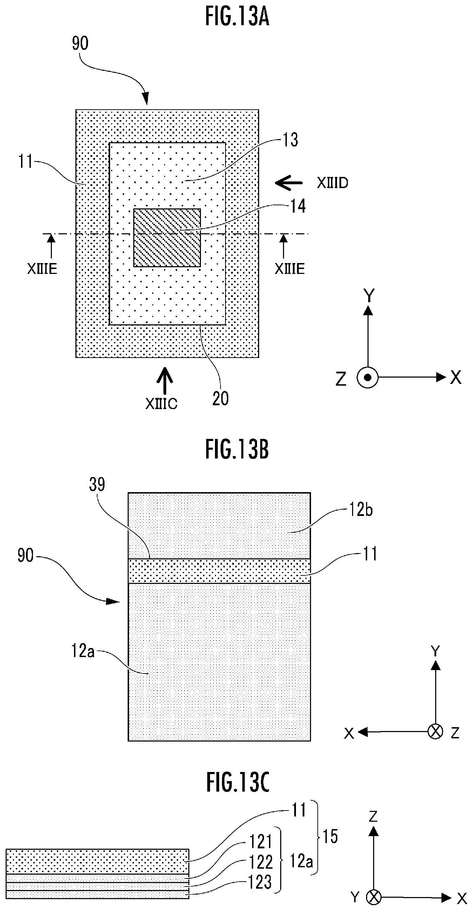

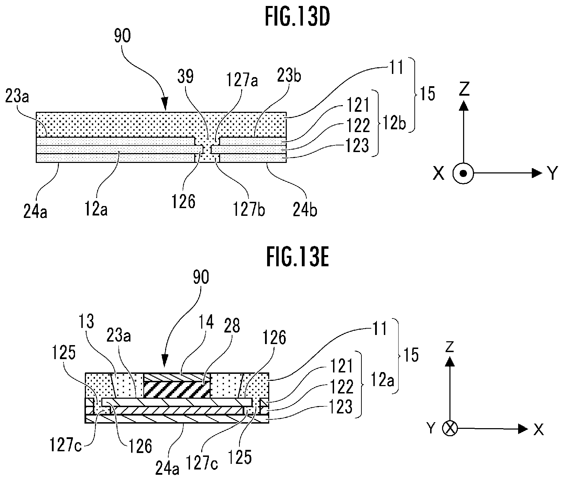

Hereinafter, a second embodiment will be described. FIGS. 13A to 13E relate to a light-emitting device 90. FIG. 13A is a top view schematically illustrating an upper surface of the light-emitting device 90. FIG. 13B is a bottom view of the light-emitting device 90. Further, FIG. 13C is a side view viewed from a direction indicated by XIIIC of FIG. 13A, FIG. 13D is a side view viewed from a direction indicated by XIIID of FIG. 13A, and FIG. 13E is a sectional view taken along XIIIE-XIIIE of FIG. 13A.

An upper surface shape of the light-emitting device 90 is rectangular, and as illustrated in FIG. 13A, the frame body 11 is disposed on an outer periphery, the opening portion 20 of the frame body 11 is embedded in the covering member 13, and the upper surface of the phosphor plate 14 is exposed at a central portion of the covering member 13. In addition, as illustrated in FIG. 13B, on a bottom surface of the light-emitting device 90, the separated rectangular leads 12a and 12b are disposed in the longitudinal direction (Y direction), and the resin of the frame body 11 is embedded in the slit 39 between the separated leads 12a and 12b.

As illustrated in FIG. 13C, on a rectangular side surface (side surface on a short side) of the light-emitting device 90 viewed from the direction XIIIC, the lead 12a is disposed in a lower portion and the frame body 11 is disposed in an upper portion in a layered shape. A rectangular side surface (side surface on a long side) of the light-emitting device 90 viewed from the direction XIIID has a structure in which the leads 12a and 12b are disposed at the lower portion, the frame body 11 is disposed at the upper portion in a layered shape, and the resin of the frame body 11 fills the slit 39 which is a separation portion between the leads 12a and 12b.

Next, a configuration of the penetration portion 125 in the light-emitting device 90 will be described in detail with reference to a sectional view of FIG. 13E. Note that, FIG. 13E is a sectional view illustrating a section crossing the lead 12a in the lateral direction (X direction). Note that, in a section crossing the lead 12b, the configuration of the penetration portion 125 is the same as the configuration of the penetration portion 125 of FIG. 13E, except that the lead 12a of FIG. 13E is replaced with the lead 12b.

In the light-emitting device 90, as illustrated in FIG. 13E, the penetration portion 125 other than the slit 39 is formed as the hole having the upper surface of the third layer metal plate 123 as the bottom surface, inside the peripheral edge of the lead frame 12.

That is, in the light-emitting device 90, the penetration portion 125 is formed along an outer periphery of the light-emitting device 90, but is defined by an outer peripheral wall portions of the first layer metal plate 121 and the second layer metal plate 122 on an outer peripheral surface side of the light-emitting device 90. That is, the entire circumference of the penetration portion 125 of the light-emitting device 90 is surrounded by the first layer metal plate 121 and the second layer metal plate 122.

That is, in the light-emitting device 90, the penetration portion 125 does not penetrate the lead 12a in the thickness direction. In other words, the penetration portion 125 is merely formed to communicate with only two layers of the first layer metal plate 121 and the second layer metal plate 122. That is, the penetration portion 125 is blocked by the third layer metal plate 123 of a lowest layer.

In addition, in the light-emitting device 90, the protruding portion 126 is formed on the first layer metal plate 121 instead of the second layer metal plate 122, in association with the fact that a depth of the penetration portion 125 is kept to two layers of the uppermost layer from the upper surface of the lead frame 12. Accordingly, the step within the penetration portion 125 is formed in the expansion portion 127c below the protruding portion 126 of the first layer metal plate 121.

When the frame body 11 is separated from the lead frame 12 in a direction perpendicular to a principal surface of the lead frame 12, the frame body 11 comes into contact with the upper protruding portion 126 at the step, and the movement is hindered. Accordingly, similarly to the light-emitting device 10 according to the first embodiment, the adhesiveness between the frame body 11 and the lead frame 12 is also improved in the light-emitting device 90.

In the first embodiment and the second embodiment, the following effects are also exhibited by the structure.

In the light-emitting devices 10 and 90, the lead frame 12 includes the plurality of leads 12a and 12b formed as the common stacked structure including the first layer metal plate 121, the second layer metal plate 122, and the third layer metal plate 123 that are continuously arrayed in order from top. In the stacked structure, the penetration portion 125 that penetrates at least two layers from the upper surface of the stacked structure is formed (for example, FIG. 13E), and the first layer metal plate 121 and the second layer metal plate 122 protrude with different amounts of protruding with respect to the penetration portion 125 to form the step. Then, the resin of the frame body 11 fills the penetration portion 125 (for example, FIGS. 5 and 13E).

Accordingly, the frame body 11 comes into contact with the step of the penetration portion 125 with respect to a separation force for separating the frame body 11 and the lead frame 12 from each other, and thus, movement in a separation direction is hindered. Thus, the adhesiveness between the frame body 11 and the lead frame 12 is improved. Further, as a result, it is possible to prevent the metal of the frame body 11 and the lead frame 12 from peeling off from each other and to form a structure that is less likely to cause poor connection of the bonding wires 43a and 43b with respect to strong vibration during dicing.

In the light-emitting devices 10 and 90, the protruding portion 126 is formed on each of the second layer metal plate 122 (for example, FIG. 5) and the first layer metal plate 121 (for example, FIG. 13E), respectively. Accordingly, the frame body 11 comes into contact with the step in a movement in which the frame body 11 is to be separated from the lead frame 12, and the movement is hindered. Thus, the separation can be effectively prevented.

In the light-emitting devices 10 and 90, the slit 39 also serves as the penetration portion, and thus, the formation space of the penetration portion can be saved.

In the light-emitting device 10, the leads 12a and 12b have a three-layer stacked structure of the first layer metal plate 121, the second layer metal plate 122, and the third layer metal plate 123. Accordingly, the number of steps formed by the protruding portion 126 is increased, and the adhesiveness between the frame body 11 and the lead frame 12 can be further improved.

Although the first embodiment, the modification example of the first embodiment, and the second embodiment have been described above, the shape of each part, the material, the dimension, and the like can be changed within the scope of the gist of the present invention. For example, the modification example of the first embodiment can also be applied to the second embodiment.

In the embodiments, the LED 28 is used as a semiconductor light-emitting element. The light-emitting element of the present invention is not limited to the LED 28, and another light-emitting element, for example, a vertical cavity surface emitting laser can also be selected.

The light-emitting devices 10 and 90 according to the embodiments have two leads 12a and 12b. The light-emitting device of the embodiments of the present invention may have three or more leads. For example, when the light-emitting device 10 or 90 includes the plurality of light-emitting elements, the number of leads can be set to be three or more.

In the light-emitting devices 10 and 90 according to the embodiments, the opening portion 20 has a shape of an inverted quadrangular pyramid, but the present invention is not limited thereto. The opening portion 20 may have a shape of a truncated cone (including an elongated truncated cone), a square column, a circular column, or the like.

The structure of the penetration portion having the step according to the lead frame having the stacked structure in the lead frame of the present invention can be applied to a general electromagnetic compatibility (EMC) package.

In the light-emitting device 10 according to the embodiment, the amount of protruding to the penetration portion 125 is maximized in the second layer metal plate 122 among the three layers of the first layer metal plate 121, the second layer metal plate 122, and the third layer metal plate 123 (see FIG. 6). The amount of protruding can be minimized in the second layer metal plate 122 among the three layers. Further, in the light-emitting device 10, the amount of protruding of the first layer metal plate 121 and the amount of protruding of the third layer metal plate 123 are equal to each other, but may be different from each other. That is, all the amounts of protruding of the first layer metal plate 121, the second layer metal plate 122, and the third layer metal plate 123 with respect to the penetration portion 125 of the light-emitting device 10 can also be different from each other.

In addition, in the light-emitting devices 10 and 90 according to the embodiments, it is preferable that thicknesses (in the Z direction) of the first layer metal plate 121, the second layer metal plate 122, and the third layer metal plate 123 are set to be equal to each other in view of manufacturing simplicity and the cost. However, the thicknesses of the metal plates 121, 122, and 123 may be different from each other.

For example, in a case where the protruding portion 126 is provided in the first layer metal plate 121, it is preferable that the thickness of the first layer metal plate 121 is smaller than the other second and third layer metal plates 122 and 123. Accordingly, since a resin volume to fill below the protruding portion 126 of the penetration portion 125 can be increased, peeling-resistance strength between the lead frames 12 and 66 and the frame body 11 can be improved. In this manner, the thicknesses of the metal plates 121, 122, and 123 can be appropriately adjusted in accordance with the structure of the penetration portion 125.

As described in detail above, according to the present invention, it is possible to provide a light-emitting device having a structure, which has excellent adhesiveness between a frame body made of resin and a lead frame made of metal, prevents the resin of the frame body and the lead frame from being peeled off, and is unlikely to cause a disconnection failure or the like, and a method for manufacturing a light-emitting device.

### Description of Reference Numerals

10, 90: light-emitting device
11: frame body
12, 66: lead frame
12a, 12b: lead
20: opening portion
28: LED (light-emitting element)
39: slit
121: first layer metal plate
122: second layer metal plate
123: third layer metal plate
125: penetration portion
126: protruding portion
127a, 127b: expansion portion.

## Claims

1. A light-emitting device comprising:
a lead frame that has a plurality of leads formed from a common stacked structure in which at least two layers are stacked, the plurality of leads having a penetration portion penetrating at least two layers from an upper layer of the stacked structure, and an upper side layer and a lower side layer of two layers having the penetration portion protruding with different amounts of protruding with respect to the penetration portion to form a step;
a frame body made of resin that has an opening portion through which the plurality of leads is exposed, the frame body filling the penetration portion, and being provided to surround the opening portion in an upper portion of the lead frame; and
a light-emitting element that is mounted within the opening portion and is connected to the plurality of leads.

2. The light-emitting device according to claim 1,
wherein the amount of protruding of the upper side layer is larger than the amount of protruding of the lower side layer.

3. The light-emitting device according to claim 1 or 2, further comprising:
a slit that separates the plurality of leads from each other, and serves as the penetration portion.

4. The light-emitting device according to any one of claims 1 to 3,
wherein the stacked structure of the lead frame has a three-layer stacked structure of a first layer, a second layer, and a third layer continuous in order from top to bottom, and
the upper side layer and the lower side layer are the first layer and the second layer, respectively, or the second layer and the third layer, respectively.

5. The light-emitting device according to claim 4,
wherein the second layer protrudes into the penetration portion from the first layer and the third layer.

6. A lead frame comprising:
a plurality of leads formed from a common stacked structure in which at least two layers are stacked,
wherein the plurality of leads has a penetration portion penetrating at least two layers from an upper layer of the stacked structure, and
an upper side layer and a lower side layer of two layers having the penetration portion protrude with different amounts of protruding with respect to the penetration portion to form a step.

7. The lead frame according to claim 6,
wherein the amount of protruding of the upper side layer is larger than the amount of protruding of the lower side layer.

8. The lead frame according to claim 6 or 7, further comprising:
a slit that separates the plurality of leads from each other, and serves as the penetration portion.

9. The lead frame according to any one of claims 6 to 8,
wherein the stacked structure has a three-layer stacked structure of a first layer, a second layer, and a third layer continuous in order from top to bottom,
the first layer is an uppermost layer of the stacked structure, and
the upper side layer and the lower side layer are the first layer and the second layer, respectively, or the second layer and the third layer, respectively.

10. The lead frame according to claim 9,
wherein the second layer protrudes into the penetration portion from the first layer and the third layer.

## Amended claims

### Amended claims under Art. 19.1 PCT

1. (Amended) A light-emitting device comprising:
a lead frame that has a plurality of leads formed from a common stacked structure in which at least two layers are stacked, the plurality of leads having a penetration portion penetrating at least two layers from an upper layer of the stacked structure, and an upper side layer and a lower side layer of two layers having the penetration portion protruding with different amounts of protruding with respect to the penetration portion to form a step;
a frame body made of resin that has an opening portion through which the plurality of leads is exposed, the frame body filling the penetration portion, and being provided to surround the opening portion in an upper portion of the lead frame; and
a light-emitting element that is mounted within the opening portion and is connected to the plurality of leads,
wherein the plurality of leads made of same metal material is stacked, and, on at least a surface of the plurality of leads exposed through the opening portion, a metal material different from a material of the surface is stacked.

2. The light-emitting device according to claim 1,
wherein the amount of protruding of the upper side layer is larger than the amount of protruding of the lower side layer.

3. The light-emitting device according to claim 1 or 2, further comprising:
a slit that separates the plurality of leads from each other, and serves as the penetration portion.

4. The light-emitting device according to any one of claims 1 to 3,
wherein the stacked structure of the lead frame has a three-layer stacked structure of a first layer, a second layer, and a third layer continuous in order from top to bottom, and
the upper side layer and the lower side layer are the first layer and the second layer, respectively, or the second layer and the third layer, respectively.

5. The light-emitting device according to claim 4,
wherein the second layer protrudes into the penetration portion from the first layer and the third layer.

6. (Amended) A lead frame comprising:
a plurality of leads formed from a common stacked structure in which at least two layers are stacked,
wherein the plurality of leads has a penetration portion penetrating at least two layers from an upper layer of the stacked structure,
an upper side layer and a lower side layer of two layers having the penetration portion protrude with different amounts of protruding with respect to the penetration portion to form a step, and
the plurality of leads made of a same metal material is stacked, and, on a surface of the plurality of leads, a metal material different from a material of the surface is stacked.

7. The lead frame according to claim 6,
wherein the amount of protruding of the upper side layer is larger than the amount of protruding of the lower side layer.

8. The lead frame according to claim 6 or 7, further comprising:
a slit that separates the plurality of leads from each other, and serves as the penetration portion.

9. The lead frame according to any one of claims 6 to 8,
wherein the stacked structure has a three-layer stacked structure of a first layer, a second layer, and a third layer continuous in order from top to bottom,
the first layer is an uppermost layer of the stacked structure, and
the upper side layer and the lower side layer are the first layer and the second layer, respectively, or the second layer and the third layer, respectively.

10. The lead frame according to claim 9,
wherein the second layer protrudes into the penetration portion from the first layer and the third layer.
